Europäisches Patentamt

European Patent Office

Office européen des brevets

(11) Veröffentlichungsnummer: **0 156 987**
**A2**

## (12) EUROPÄISCHE PATENTANMELDUNG

(21) Anmeldenummer: **84115541.9**

(22) Anmeldetag: **15.12.84**

(51) Int. Cl.⁴: **H 05 K 1/03**

(30) Priorität: **31.03.84 DE 3412447**

(43) Veröffentlichungstag der Anmeldung: **09.10.85**
**Patentblatt 85/41**

(84) Benannte Vertragsstaaten: **CH DE FR GB IT LI NL SE**

(71) Anmelder: **SCHERING AKTIENGESELLSCHAFT Berlin und Bergkamen,**
**Müllerstrasse 170/178 Postfach 65 03 11,**
**D-1000 Berlin 65 (DE)**

(72) Erfinder: **Wolff, Joachim, Thielallee 23,**
**D-1000 Berlin 33 (DE)**
Erfinder: **Prior, Günter, Nordhauser Strasse 13,**
**D-1000 Berlin 10 (DE)**

(54) **Verfahren zur Herstellung von gedruckten Schaltungen.**

(57)   Die Erfindung betrifft ein Verfahren zur Herstellung von gedruckten Schaltungen mit großer Haftfestigkeit und Kantenschärfe der Leiterzüge, insbesondere zur Durchkontaktierung von gebohrten Leiterplatten, unter Verwendung von nichtbeschichtetem oder beschichtetem Basismaterial, welches in an sich bekannter Weise gebohrt, gereinigt, aktiviert, reduziert und in üblicher Weise weiterbehandelt wird, dadurch gekennzeichnet, dass die Platten unmittelbar vor oder nach erfolgter Aktivierung oder Reduzierung auf Temperaturen von 75° bis 400 °C, vorzugsweise von 100 °C bis 150 °C, erhitzt werden.

Die Erfindung betrifft ein Verfahren zur Herstellung von gedruckten Schaltungen mit hoher Belegungsdichte und Haftfestigkeit der Leiterzüge gemäß Oberbegriff des Anspruchs 1.

Verfahren zur Herstellung von gedruckten Schaltungen sind bereits bekannt. Alle diese Verfahren erfordern eine Vorbehandlung der zunächst nicht leitenden Oberfläche, was in der Regel durch deren Aktivierung mittels ionischer kolloidaler oder subkolloidaler Edelmetallkomplexe und anschließender Behandlung mit einem Reduktionsmittel erfolgt.
Trotz großer Fortschitte und Verbesserungen lösen diese Verfahren jedoch nicht das Bedürfnis, eine integrierte Verbindung des metallischen Belags mit der nichtleitenden Oberfläche zu bewirken, da - systemimmanent - höchstens eine in der Größenordnung einer Chemiesorption liegende Belegung der Oberfläche erfolgt.

Aufgabe der Erfindung ist daher die Schaffung eines Verfahrens, welches eine integrierte, verbundartige Verbindung des metallischen Belags mit der Oberfläche des Nichtleiters und dadurch die Herstellung außerordentlich haftfester und kantenscharfer Leiterzüge ermöglicht.

Diese Aufgabe wird durch den im Anspruch 1 gekennzeichneten Gegenstand gelöst.
Vorteilhafte Weiterbildungen dieses Gegenstandes sind in den Unteransprüchen beschrieben.

Das erfindungsgemäße Verfahren ermöglicht in bisher nicht erreichter Weise die Herstellung von gedruckten Schaltungen mit großer Haftfestigkeit und Kantenschärfe der Leiterzüge, die innig bzw. verbundartig mit der Oberfläche des Basismaterials verbunden sind.

Ein besonderer Vorteil ist es, daß sich erfindungsgemäß nicht nur die Oberfläche des nichtbeschichteten oder des beschichteten Basismaterials im gewünschten Sinne metallisieren läßt, sondern daß sich auch Durchkontaktierungen der Bohrungen von Leiterplatten herstellen lassen, die höchsten Ansprüchen genügen.

Postanschrift: Schering Aktiengesellschaft, Postfach 65 03 11, D-1000 Berlin 65 · Für Besucher Berlin-Wedding, Müllerstraße 170-178 Telegramme Scheringchemie Berlin

Vorstand Dr Herbert Asmis Dr Christian Bruhn Dr Heinz Hannse, Horst Kramp, Dr Klaus Pohle Dr Horst Witzel · Vorsitzender des Aufsichtsrats Hans-Jürgen Hamann Sitz der Gesellschaft Berlin und Bergkamen Handelsregister AG Charlottenburg 93 HRB 283 und AG Kamen HRB 0061 Berliner Commerzbank AG. Berlin Konto-Nr 108700600 Bankleitzahl 100 400 00 Berliner Handels- und Frankfurter Bank, Berlin, Konto-Nr 70045224 Bankleitzahl 100 202 00 Deutsche Bank Berlin AG. Konto-Nr 2415008 Bankleitzahl 100 700 00 Postscheckamt Berlin West, Konto-Nr 1175-101 Bankleitzahl 100 100 10

Da sich das erfindungsgemäße Verfahren universell für die durch geeignete Aktivatoren mit nachfolgender Reduzierung leitend gemachte Oberflächen von Nichtleitern mit Erfolg einsetzen läßt, gehört auch die Herstellung von galvanisierten Kunststoffen jeder Art sowie die Metallisierung von keramischen Materialien, wie Aluminiumoxid, Keramik, Berylliumoxid, Bariumtitanate oder Quarz, zum Gegenstand der vorliegenden Erfindung.

Die einzelnen Behandlungsschritte bei der Durchführung des erfindungsgemäßen Verfahrens bis vor und nach der Erhitzungsstufe sind an sich bereits bekannt und können vom Fachmann je nach Aufgabenstellung im wesentlichen unverändert durchgeführt werden.

Die vorteilhaften Effekte des erfindungsgemäßen Verfahrens können sich jedoch nur dann voll entfalten, wenn die Erhitzung unmittelbar vor oder nach der Aktivierung oder nach der Reduzierung durchgeführt wird.

Eine Wiederholung zur Erhitzung nach der Weiterbehandlung in üblicher, gewünschter Weise, beispielsweise nach dem Laminieren, Belichten und Entwickeln, kann gegebenenfalls von besonderem Vorteil sein.

Die erfindungsgemäße Erhitzung kann mit hierfür bekannten Mitteln, wie in entsprechenden Öfen oder mittels Infrarotstrahlung, zum Beispiel Umlufttrocknung, erfolgen.

Die große Anwendungsbreite des erfindungsgemäßen Verfahrens ermöglicht den Einsatz beliebiger Materialien, von denen in den Ansprüchen einige bevorzugte aufgeführt sind.

Es läßt sich demzufolge bei allen bisher bekannten Techniken einsetzen, wie zum Beispiel bei Additivverfahren, bei Subtraktivverfahren und bei der selektiven Lötaugen- und Bohrlochverkupferung.

Die erfindugnsgemäß hergestellten Produkte finden insbesondere Verwendung in der Elektrotechnik und Elektronik.
Das folgenden Beispiel dient zur Erläuterung des erfindungsgemäßen Verfah-rens.

Postanschrift: Schering Aktiengesellschaft, Postfach 65 03 11, D-1000 Berlin 65 · Für Besucher: Berlin-Wedding, Müllerstraße 170-178 · Telegramme: Scheringname Berlin

Vorstand: Dr. Herbert Asmis, Dr. Christian Bruhn, Dr. Heinz Hannse, Horst Kramp, Dr. Klaus Pohle, Dr. Horst Witzel · Vorsitzender des Aufsichtsrats: Hans-Jürgen Hamann · Sitz der Gesellschaft: Berlin und Bergkamen · Handelsregister: AG Charlottenburg 93 HRB 283 und AG Kamen HRB 006 · Berliner Commerzbank AG, Berlin, Konto-Nr. 103700600, Bankleitzahl 100 400 00 · Berliner Handels- und Frankfurter Bank, Berlin, Konto-Nr. 70045224, Bankleitzahl 100 202 00 · Deutsche Bank Berlin AG, Konto-Nr. 245008, Bankleitzahl 100 700 00 · Postscheckamt Berlin West, Konto-Nr. 175-101, Bankleitzahl 100 100 10

## B E I S P I E L

Ein mit Haftvermittler beschichtetes Basismaterial aus glasfaserverstärktem epoxydharz wird gebohrt und chemisch und/oder mechanisch vom Bohrmehl befreit.

Die Platte wird in Lösungsmittel aufgequollen, mit Wasser gespült und in einer Chrom-Schwefelsäure aufgeschlossen. (200 - 300 ml/l $H_2SO_4$, 10-100 g/l $CrO_3$).

Anschließend wird gespült, entgiftet und gespült.
Nachfolgend wird in einem ionogenen Aktivator auf Basis Palladium aktiviert, gespült und getrocknet, dann mit einer Natriumborhydrid-Lösung reduziert.

In einem weiteren Schritt wird 10 Minuten auf 140° C erhitzt.
Nach dem Erhitzen erfolgt Beschichtung mit einem Fotopolymer.
Dann erfolgt die Belichtung auf UV-Licht, worauf anschließend nach einer Reaktionszeit in Trichloräthan entwickelt wird.

Das freigelegte zu metallisierende Schaltbild und die Bohrlöcher werden noch einmal selektiv reduziert.
Anschließend erfolgt der Kupferaufbau auf Leiterzügen, Lötaugen und Lochwandungen in einem wäßrigen chemischen Kupferbad.

Nach Aufbau der gewünschten Kupferschicht erfolgt das Strippen des Fotopolymers durch Behandlung mit Methylenchlorid.
Nach einem Bürstenvorgang der Leiterplatte wird diese mit einem Lötstoppdruck versehen und die Lötaugen und Bohrlöcher heiß verzinnt.

-6-

Postanschrift: Schering Aktiengesellschaft, Postfach 65 03 11, D-1000 Berlin 65 · Für Besucher: Berlin-Wedding, Müllerstraße 170-178 Telegramme Scheringchemie Berlin

Vorstand: Dr. Herbert Asmis, Dr. Christian Bruhn, Dr. Heinz Hannse, Horst Kramp, Dr. Klaus Pohle, Dr. Horst Witzel · Vorsitzender des Aufsichtsrats: Hans-Jürgen Hamann
Sitz der Gesellschaft: Berlin und Bergkamen Handelsregister: AG Charlottenburg 93 HRB 283 und AG Kamen HRB 0061 Berliner Commerzbank AG, Berlin Konto-Nr.
108700600 Bankleitzahl 100 400 00 Berliner Handels- und Frankfurter Bank, Berlin, Konto-Nr. 70045224, Bankleitzahl 100 202 00 Deutsche Bank Berlin AG, Konto-Nr.
2415009, Bankleitzahl 100 700 00 · Postscheckamt Berlin West, Konto-Nr. 1175-101, Bankleitzahl 100 100 10

Schering Aktiengesellschaft
Gewerblicher Rechtsschutz

## PATENTANSPRÜCHE

1. Verfahren zur Herstellung von gedruckten Schaltungen mit großer Haftfestigkeit und Kantenschärfe der Leiterzüge, insbesondere zur Durchkontaktierung von gebohrten Leiterplatten, unter Verwendung von nichtbeschichtetem oder beschichtetem Basismaterial, welches in an sich bekannter Weise gebohrt, gereinigt, aktiviert, reduziert und in üblicher Weise weiterbehandelt wird, dadurch gekennzeichnet, daß die Platten unmittelbar vor oder nach erfolgter Aktivierung oder Reduzierung auf Temperaturen von 75° bis 400° C, vorzugsweise von 100° bis 150°C, erhitzt werden.

2. Verfahren gemäß Anspruch 1, dadurch gekennzeichnet, daß die Platten von 5 Minuten bis zu 2 Stunden, vorzugsweise 30 Minuten, erhitzt werden.

3. Verfahren gemäß Anspruch 1, dadurch gekennzeichnet, daß die Aktivierung durch ionische, kolloidale oder subkolloidale Edelmetallkomplexe oder Nicht-Edelmetall-Katalysatoren erfolgt.

4. Verfahren gemäß Anspruch 1, dadurch gekennzeichnet, daß die Aktivierung mittels einer wäßrigen alkalischen Lösung eines Edelmetallkomplexes, vorzugsweise aus Palladiumsalz und 2-Aminopyridin, erfolgt.

5. Verfahren gemäß Anspruch 1, dadurch gekennzeichnet, daß die Reduktion mittels Alkalihypophosphit, Natriumborhydrid oder Dimethylaminoboran durchgeführt wird.

6. Verfahren gemäß Anspruch 1, dadurch gekennzeichnet, daß als Basismaterial glasfaserverstärktes Epoxidharz, Phenolharzpapier, Epoxidharzpapier, Plexiglas, Polysulfon, Polyimid, Polyamid, Polyphenylenoxyd-Polysterol, Fluorkohlenwasserstoff, Polycarbonate, Polyätherimid oder keramisches Material verwendet wird.

7. Verfahren gemäß Anspruch 1, dadurch gekennzeichnet, daß als beschichtetes Basismaterial ein Träger verwendet wird, desssen Oberfläche mit einer festhaftenden, durch Wärme aushärtbaren Schicht versehen ist, die mindestens einen Stoff enthält, der der Gruppe der modifizierten Gummi bzw. Kunstgummi angehört und durch geeignete Oxydationsmittel oxydierbar bzw.

**Postanschrift: Schering Aktiengesellschaft, Postfach 65 03 11, D-1000 Berlin 65** · Für Besucher Berlin-Wedding, Müllerstraße 170-178   Telegramme: Scheringchemie Berlin

Vorstand: Dr. Herbert Asmis, Dr. Christian Bruhn, Dr. Heinz Hannne, Horst Kramp, Dr. Klaus Pohle, Dr. Horst Witzel · Vorsitzender des Aufsichtsrats: Hans-Jürgen Hamann
Sitz der Gesellschaft: Berlin und Bergkamen · Handelsregister: AG Charlottenburg 93 HRB 283 und AG Kamen HRB 0061 · Berliner Commerzbank AG, Berlin, Konto-Nr.
10070000, Bankleitzahl 100 400 00 · Berliner Handels- und Frankfurter Bank, Berlin, Konto-Nr. 70045224, Bankleitzahl 100 202 00 · Deutsche Bank Berlin AG, Konto-Nr.
0413126, Bankleitzahl 100 700 00 · Postscheckamt Berlin West, Konto-Nr. 1175-101, Bankleitzahl 100 100 10

0156987
SCHERING

abbaubar ist.

8. Verfahren gemäß Anspruch 1, dadurch gekennzeichnet, daß als Basismaterial ein Träger verwendet wird,, dessen Oberfläche mit einem Mittel, vorzugsweise Kupfer, ein- oder beidseitig beschichtet ist.

9. Gedruckte Schaltungen hergestellt gemäß Ansprüchen 1 bis 8.

10. Durchkontaktierte Leiterplatten, hergestellt gemäß Ansprüchen 1 bis 8.

11. Galvanisierte Kunststoffe, hergestellt gemäß Ansprüchen 1 bis 8

-3-

Postanschrift: Schering Aktiengesellschaft, Postfach 65 03 11, D-1000 Berlin 65 · Für Besucher: Berlin-Wedding. Müllerstraße 170-178   Telegramme Scheringchemie Berlin

Vorstand Dr Herbert Asmis, Dr Christian Brunn. Dr Heinz Hannse. Horst Kramp. Dr. Klaus Pohle, Dr. Horst Witzel   Vorsitzender des Aufsichtsrats Hans-Jürgen Hamann
Sitz der Gesellschaft Berlin und Bergkamen   Handelsregister: AG Charlottenburg 93 HRB 283 und AG Kamen HRB 0061   Berliner Commerzbank AG Berlin Konto-Nr
108700600. Bankleitzahl 100 400 00   Berliner Handels- und Frankfurter Bank, Berlin, Konto-Nr 70045224. Bankleitzahl 100 202 00   Deutsche Bank Berlin AG, Konto-Nr
2415008. Bankleitzahl 100 700 00   Postscheckamt Berlin West, Konto-Nr. 11 75-101 Bankleitzahl 100 100 10